# EUROPEAN PATENT APPLICATION

(11) **EP 4 790 709 A1**
(43) Date of publication of application: **12.08.2026**
(21) Application number: 25197476.2
(22) Date of filing: 21.08.2025
(51) Int. Cl.: G11C 7/06, G11C 11/16, G11C 13/00

(54) **MEMORY DEVICE**

(30) Priority: 10.02.2025 JP 2025020164
(71) Applicant: Kioxia Corporation, Tokyo 108-0023 (JP)
(72) Inventor: KATAYAMA, Akira, Tokyo, 108-0023 (JP); HATSUDA, Kosuke, Tokyo, 108-0023 (JP)
(74) Representative: Marks & Clerk LLP

(57) **Abstract**

A first memory cell includes a first variable resistance element and a first switching element coupled to the first variable resistance element. A first interconnect is coupled to the first memory cell. A first switch has a first end and a second end, the first end being coupled to the first interconnect. A second interconnect is coupled to the second end. A first pre-charge circuit is coupled to the second interconnect. A first transistor has a third end, a fourth end, and a gate, the third end being coupled to a first node receiving a first voltage, the gate being coupled to the first interconnect. A third interconnect is coupled to the fourth end of the first transistor. A sense amplifier circuit is coupled to the third interconnect.

## Description

### CROSS-REFERENCE TO RELATED APPLICATION

This application is based upon and claims the benefit of priority from Japanese Patent Application No. 2025-020164, filed February 10, 2025.

### FIELD

Embodiments described herein relate generally to a memory device.

### BACKGROUND

There are known memory devices using a magnetoresistance effect element. The memory device is required to operate at a high speed.

### BRIEF DESCRIPTION OF DRAWINGS

FIG. 1 is a block diagram of a memory device of a first embodiment.
FIG. 2 is a block diagram of a core circuit of the memory device of the first embodiment.
FIG. 3 is a diagram illustrating components of a GWL selector and a GBL selector of the memory device of the first embodiment and coupling of the components.
FIG. 4 is a diagram illustrating functional blocks of a sub-core circuit of the memory device of the first embodiment.
FIG. 5 is a diagram illustrating components of a WL selector and a BL selector of the memory device of the first embodiment and coupling of the components.
FIG. 6 is a perspective view of a part of a memory cell array of the memory device of the first embodiment.
FIG. 7 is a diagram illustrating an example of a cross section of a structure of a memory cell of the memory device of the first embodiment.
FIG. 8 is a diagram illustrating an example of characteristics of a voltage and a current of a memory cell of the memory device of the first embodiment.
FIG. 9 is a diagram illustrating components of a conversion circuit and a read circuit of the memory device of the first embodiment, coupling of the components, and related components.
FIG. 10 is a diagram illustrating components of a sense amplifier circuit of a memory device according to the first embodiment and coupling of the components.
FIG. 11 is a diagram illustrating an example of components of the read circuit of the memory device of the first embodiment and coupling of the components.
FIG. 12 is a diagram illustrating a flow of data reading in the memory device of the first embodiment.
FIG. 13 is a diagram illustrating potentials of several signals and interconnects along time during data reading of the memory device of the first embodiment.
FIG. 14 is a diagram illustrating some components of the memory device of the first embodiment, coupling of the components, and related components.

### DETAILED DESCRIPTION

In general, according to one embodiment, a memory device includes a first memory cell, a first interconnect, a first switch, a second interconnect, a first transistor, a third interconnect, a sense amplifier circuit. The first memory cell includes a first variable resistance element and a first switching element coupled to the first variable resistance element. The first interconnect is coupled to the first memory cell. The first switch has a first end and a second end, the first end being coupled to the first interconnect. The second interconnect is coupled to the second end. The first pre-charge circuit is coupled to the second interconnect. The first transistor has a third end, a fourth end, and a gate, the third end being coupled to a first node receiving a first voltage, the gate being coupled to the first interconnect. The third interconnect is coupled to the fourth end of the first transistor. The sense amplifier circuit is coupled to the third interconnect.

Embodiments will now be described with reference to the figures. In order to distinguish components having substantially the same function and configuration in an embodiment or over different embodiments from each other, an additional numeral or letter may be added to the end of each reference numeral or letter. In the following description, in an embodiment following an embodiment that is already described, different points from the already described embodiment are mainly described. The entire description of a particular embodiment applies to another embodiment unless an explicit mention is made otherwise, or an obvious elimination is involved.

Each functional block may be implemented as hardware, computer software, or their combination. It is not necessary that functional blocks be distinguished as in the following examples. Some of the functions may be implemented by functional blocks different from those illustrated below, or by smaller functional sub-blocks.

The specification and the claims, when mentioning that a particular (first) component is "coupled" to another (second) component, intend to cover both the form of the first component directly coupled to the second component and the form of the first component coupled to the second component via one or more components which are always or selectively conductive.

Embodiments will be described using a three-dimensional orthogonal coordinate system. A direction of an x axis is referred to as an X direction. A direction opposite to the X direction is referred to as a -X direction. A direction of a y axis is referred to as a Y direction. A direction opposite to the Y direction is referred to as a -Y direction. A direction of a z axis is referred to as a Z direction, and up indicates the Z direction. A direction opposite to the Z direction is referred to as a -Z direction.

### 1. First Embodiment

### 1.1. Configuration (structure)

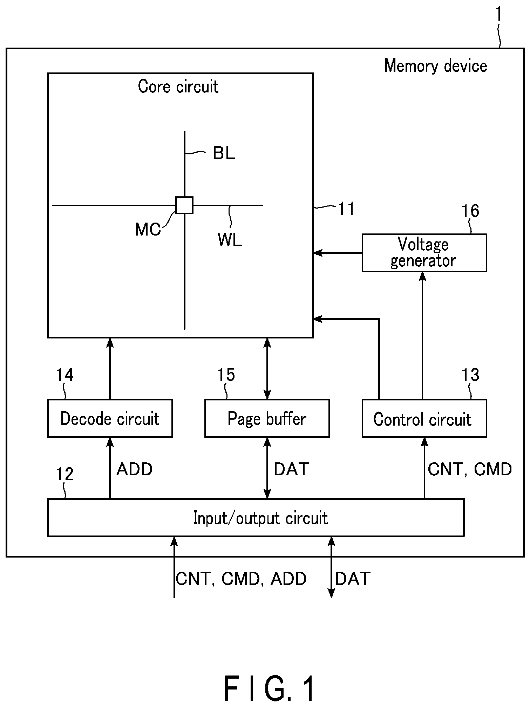

FIG. 1 illustrates functional blocks of a memory device of a first embodiment. The memory device 1 includes a core circuit 11, an input/output circuit 12, a control circuit 13, a decode circuit 14, a page buffer 15, and a voltage generator 16.

The core circuit 11 is a circuit including a plurality of memory cells MC and interconnect and a circuit for accessing the memory cells MC.

The input/output circuit 12 is a circuit that inputs and outputs data and signals. The input/output circuit 12 receives a control signal CNT, a command CMD, address information ADD, and data DAT from the outside of the memory device 1, for example, from a memory controller. The input/output circuit 12 outputs the data DAT.

The control circuit 13 receives the command CMD and the control signal CNT from the input/output circuit 12. The control circuit 13 controls the core circuit 11 based on control instructed by the command CMD and the control signal CNT, and controls data reading from the memory cells MC and data writing to the memory cells MC. The control circuit 13 controls the voltage generator 16 based on the control instructed by the command CMD and the control signal CNT.

The decode circuit 14 is a circuit that decodes the address information ADD. The decode circuit 14 receives the address information ADD from the input/output circuit 12. The decode circuit 14 decodes the address information ADD, and generates a signal for selecting a memory cell MC from or to which data is to be read or written based on a result of the decoding. The generated signal is transmitted to the core circuit 11.

The page buffer 15 is a circuit that temporarily stores data of a certain size. The page buffer 15 receives the data DAT to be written to the memory cell MC from the input/output circuit 12, temporarily stores the data, and transfers the data to the core circuit 11. The page buffer 15 receives the data read from the memory cell MC, temporarily stores the read data, and transfers the data DAT to the input/output circuit 12.

The voltage generator 16 supplies a voltage used for data writing to the core circuit 11 during the data writing to the memory cell MC. The voltage generator 16 supplies a voltage used for data reading to the core circuit 11 during the data reading from the memory cell MC.

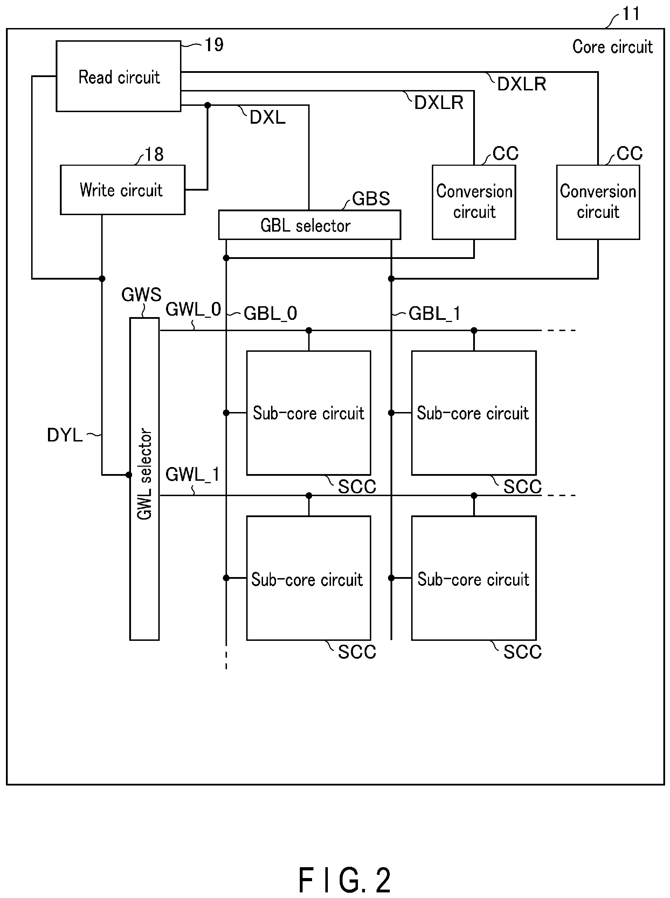

FIG. 2 illustrates functional blocks of the core circuit of the memory device according to the first embodiment. As illustrated in FIG. 2, the core circuit 11 includes a plurality of sub-core circuits SCC, a plurality of global word lines GWL, a plurality of global bit lines GBL, a GWL selector GWS, a GBL selector GBS, a plurality of conversion circuits CC, an interconnect DYL, an interconnect DXL, a plurality of interconnects DXLR, a write circuit 18, and a read circuit 19. In the following description, the terms "word line" and "bit line" are merely names for distinguishing between two types of interconnects, and may be referred to as names opposite to each other.

Each sub-core circuit SCC is a set of a plurality of components, and includes a plurality of memory cells MC, a plurality of selectors, and a plurality of interconnects. Each sub-core circuit SCC is coupled to a single global word line GWL and a single global bit line GBL.

Each global word line GWL is coupled to a plurality of sub-core circuits SCC. Each global bit line GBL is coupled to a plurality of sub-core circuits SCC.

The GWL selector GWS is a circuit that selects one of the plurality of global word lines GWL. Each GWL selector GWS receives the address information ADD or a signal based on the address information ADD, and couples a single global word line GWL specified by the received address information ADD or the signal based on the address information ADD among the plurality of global word lines GWL, to the interconnect DYL.

The interconnect DYL is coupled to the read circuit 19 and the write circuit 18.

The GBL selector GBS is a circuit that selects one of the plurality of global bit lines GBL. Each GBL selector GBS receives the address information ADD or a signal based on the address information ADD, and couples a single global bit line GBL specified by the received address information ADD or the signal based on the address information ADD among the plurality of global bit lines GBL, to the interconnect DXL.

Each conversion circuit CC is a circuit that converts a current into a voltage. Each conversion circuit CC is coupled between a single global bit line GBL and a single interconnect DXLR. The conversion circuit CC applies a voltage of a magnitude based on the current flowing through the global bit line GBL to the interconnect DXLR.

The interconnect DXLR is coupled to the read circuit 19.

The write circuit 18 is a circuit that controls writing of data to the memory cells MC. The write circuit 18 receives write data DAT from the input/output circuit 12 and receives a voltage for data writing from the voltage generator 16. The write circuit 18 supplies a voltage and a current used for data writing to the interconnects DXL and DYL based on the control of the control circuit 13 and the write data DAT.

The read circuit 19 is a circuit that controls reading of data from the memory cells MC. The read circuit 19 receives a voltage used for data reading from the voltage generator 16. The read circuit 19 determines the data stored in the memory cell MC using the voltage used for data reading based on the control of the control circuit 13. The determined data is supplied to the input/output circuit 12 as read data DAT. The read circuit 19 includes a plurality of sense amplifier circuits SAC. Each sense amplifier circuit SAC is a circuit that outputs data determined as being stored in the memory cell MC that is the data reading target, using a voltage based on data stored in the data-reading-target memory cell MC. Details of the sense amplifier circuits SAC will be described later.

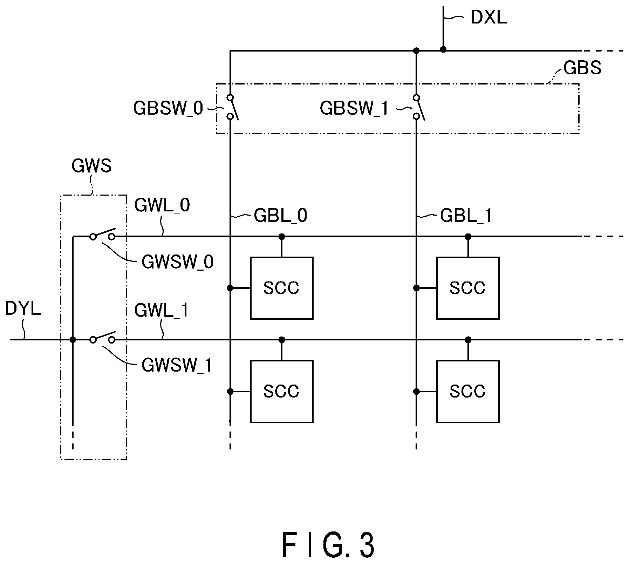

FIG. 3 is a diagram illustrating components of the GWL selector and the GBL selector of the memory device of the first embodiment and coupling of the components. As illustrated in FIG. 3, the GWL selector GWS includes the same number of switches GWSW as the number of the sub-core circuits SCC coupled to each global bit line GBL. Each switch GWSW is coupled to the interconnect DYL at one end, and is coupled to a single global word line GWL at the other end. The switches GWSW are p-type or n-type metal oxide semiconductor field effect transistors (MOSFETs), or are p-type or n-type MOSFETs that are coupled in parallel and receive a complementary signal at their respective gates. The description of the switches GWSW also applies to the switches GWSW, WSW, BSW, SW1, SW2, SW3, SW4, SW5, SW6, SW7, SW11, and SW12 described later. Each switch GWSW is turned on or off by control of the read circuit 19 or the write circuit 18 based on the address information ADD or a signal based on the address information ADD.

The GBL selector GBS includes the same number of switches GBSW as the number of the sub-core circuits SCC coupled to each global word line GWL. Each switch GBSW is coupled to the interconnect DXL at one end, and is coupled to a single global bit line GBL at the other end. Each switch GBSW is turned on or off by control of the read circuit 19 or the write circuit 18 based on the address information ADD or a signal based on the address information ADD.

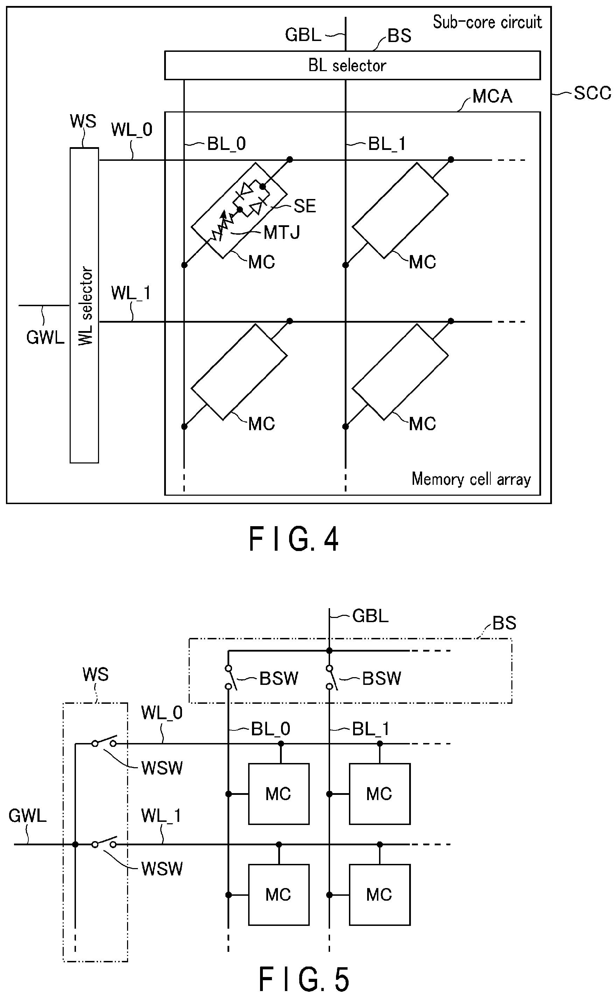

FIG. 4 is a diagram illustrating functional blocks of a sub-core circuit of the memory device of the first embodiment. As illustrated in FIG. 4, each sub-core circuit SCC includes a memory cell array MCA, a plurality of word lines WL, a plurality of bit lines BL, a WL selector WS, a BL selector BS, a global word line GWL, and a global bit line GBL.

The memory cell array MCA is a set of a plurality of arranged memory cells MC. Each memory cell MC can store data in a non-volatile manner. The word lines WL and the bit lines BL are also located in the memory cell array MCA. The following description is based on an example in which the word lines WL are associated with rows and the bit lines BL are associated with columns. Each memory cell MC is coupled to a single word line WL and a single bit line BL. One memory cell MC is identified by selection of a single row and selection of a single column.

Each word line WL is coupled to a plurality of memory cells MC. Each bit line BL is coupled to a plurality of memory cells MC.

Each memory cell MC stores data using a dynamically variable resistor and includes a variable resistance element. The variable resistance element is an element capable of switching between a low resistance state and a high resistance state. The following description is based on an example in which the variable resistance element is an MTJ element described later. Other examples of variable resistance elements include phase change elements.

Each memory cell MC includes a single MTJ element MTJ and a single switching element SE. In each memory cell MC, the MTJ element MTJ and the switching element SE are coupled in series. The switching element SE of each memory cell MC is coupled to a single word line WL. The MTJ element MTJ of each memory cell MC is coupled to a single bit line BL. The MTJ element MTJ exhibits a tunnel magnetoresistance effect, and is an element that includes a magnetic tunnel junction (MTJ) as an example. The MTJ element MTJ is also referred to as a magnetoresistance effect element MTJ. The MTJ element MTJ is a variable resistance element capable of switching between a low resistance state and a high resistance state. The MTJ element MTJ can store 1-bit data using a difference between the two resistance states. In one example, the MTJ element MTJ stores "0" data in the low resistance state and stores "1" data in the high resistance state.

The switching element SE is an element that has two terminals and performs electrical coupling or uncoupling between the two terminals. When the voltage applied between the two terminals in a first direction is less than a certain threshold voltage, the switching element SE is in a high resistance state, for example, an electrically non-conductive state (or off state). When the voltage applied between the two terminals increases to become equal to or higher than the threshold voltage, the switching element SE enters a low resistance state, for example, an electrically conductive state (or on state). When the voltage applied between the two terminals of the switching element SE in the low resistance state decreases to be less than the threshold voltage, the switching element SE enters the high resistance state. The switching element SE has the same function as the function of switching between the high resistance state and the low resistance state based on the magnitude of the voltage applied in the first direction, in a second direction opposite to the first direction. That is, the switching element SE is a bidirectional switching element. By turning on or off the switching element SE, it is possible to control the presence or absence of supply of a current to the MTJ element MTJ coupled to the switching element SE, that is, the selection or unselection of the MTJ element MTJ.

Each WL selector WS is a circuit that selects one of the plurality of word lines WL. Each WL selector WS receives the address information ADD or a signal based on the address information ADD, and couples a single word line WL specified by the received address information ADD or the signal based on the address information ADD among the plurality of word lines WL, to a single global word line GWL.

Each BL selector BS is a circuit that selects one of the plurality of bit lines BL. Each BL selector BS receives the address information ADD or a signal based on the address information ADD, and couples a single bit line BL specified by the received address information ADD or the signal based on the address information ADD among the plurality of bit lines BL, to a single global bit line GBL.

FIG. 5 is a diagram illustrating components of the WL selector and the BL selector of the memory device of the first embodiment and coupling of the components. As illustrated in FIG. 5, the WL selector WS includes the same number of switches WSW as the number of memory cells MC coupled to each bit line BL. Each switch WSW is coupled to the global word line GWL at one end, and is coupled to a single word line WL at the other end. Each switch WSW is turned on or off by control of the read circuit 19 or the write circuit 18 based on the address information ADD or a signal based on the address information ADD.

The BL selector BS includes the same number of switches BSW as the number of memory cells MC coupled to each word line WL. Each switch BSW is coupled to the global bit line GBL at one end and is coupled to a single bit line BL at the other end. Each switch BSW is turned on or off by control of the read circuit 19 or the write circuit 18 based on the address information ADD or a signal based on the address information ADD.

In the examples of FIGS. 2, 3, 4, and 5, the core circuit 11 has two layers. The lowermost first layer includes the configuration illustrated in FIG. 4, that is, a set of the memory cells MC, the word lines WL, the bit lines BL, the WL selector WS, and the BL selector BS. The second layer includes the configuration illustrated in FIG. 2, that is, a set of the sub-core circuits SCC, the global word lines GWL, the global bit lines GBL, the GWL selector GWS, and the GBL selector GBS.

The core circuit 11 may have three or more layers. When the selector in each layer is switched on, a single word line WL is coupled to the write circuit 18 and the read circuit 19. Similarly, when the selector in each layer is switched on, a single bit line BL is coupled to the write circuit 18 and the read circuit 19.

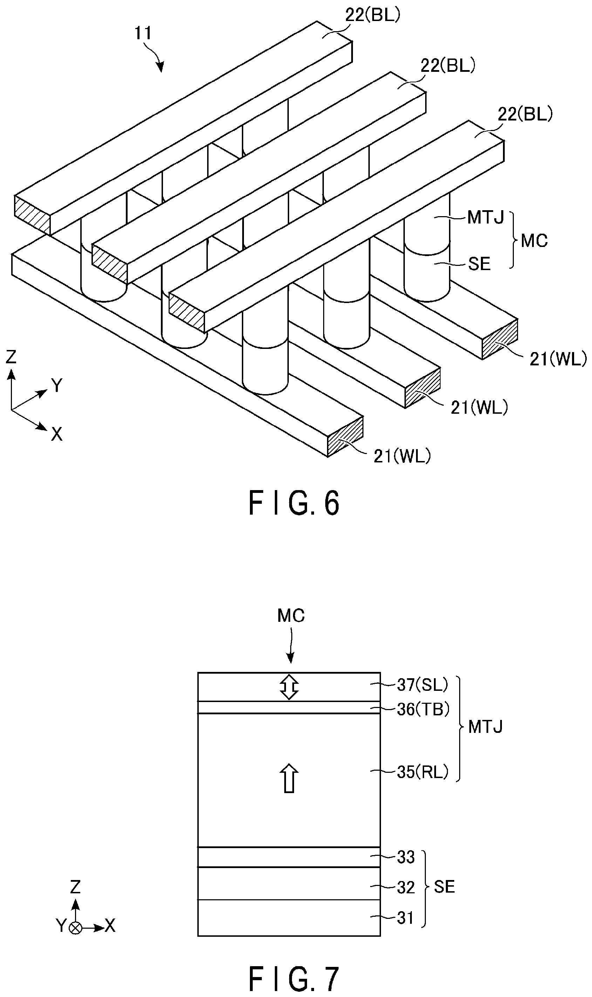

FIG. 6 is a perspective view of a part of the memory cell array of the memory device of the first embodiment. As illustrated in FIG. 6, a plurality of conductors 21 and a plurality of conductors 22 are provided.

The conductors 21 each have a linear shape, extend in the X direction, and are aligned in the Y direction. Each of the conductors 21 functions as at least a part of a single word line WL.

The conductors 22 are located farther in the Z direction than the conductors 21. The conductors 22 each have a linear shape, extend in the Y direction, and are aligned in the X direction. Each of the conductors 22 functions as at least a part a single bit line BL.

One memory cell MC is provided at each of intersections of the conductors 21 and the conductors 22. The memory cells MC are arranged in a matrix form along the xy plane consisting of the X direction and Y direction. Each memory cell MC includes a structure functioning as the switching element SE and a structure functioning as the MTJ element MTJ. Each of the structure functioning as the switching element SE and the structure functioning as the MTJ element MTJ includes one or more layers. In one example, the structure functioning as the MTJ element MTJ is located on the upper surface of the structure functioning as the switching element SE. The surface (lower surface) of each memory cell MC on the -Z direction side is in contact with the upper surface of a single conductor 21. The surface (upper surface) of each memory cell MC on the Z direction side is in contact with the lower surface of a single conductor 22.

FIG. 7 illustrates an example of a cross section of the structure of the memory cell of the memory device of the first embodiment.

The switching element SE includes a variable resistance material 32. The variable resistance material 32 is a material exhibiting dynamically variable resistance, and, in one example, has a layer shape. The variable resistance material 32 is a switching element between its two terminals where a first terminal of the two terminals is one of the upper surface and the lower surface of the variable resistance material 32, and a second terminal of the two terminals is the other of the upper surface and the lower surface of the variable resistance material 32. When a voltage applied between the two terminals is lower than a certain threshold voltage, the variable resistance material 32 is in a "high resistance" state, for example, an electrically non-conductive state. When the voltage applied between the two terminals rises to be equal to or higher than the threshold voltage, the variable resistance material 32 enters a "low resistance" state, for example, an electrically conductive state. When the voltage applied between the two terminals of the variable resistance material 32 in the low resistance state drops to be lower than the threshold voltage, the variable resistance material 32 enters the high resistance state.

In one example, the variable resistance material 32 includes an insulator and a dopant introduced into the insulator by ion implantation. The insulator includes, for example, an oxide which may be SiO₂, or a material consisting substantially of SiO₂. In one example, the dopant includes arsenic (As) and germanium (Ge). The description "consisting (or formed) substantially of" and similar terms are meant to permit a component "consisting substantially of" something to contain unintended impurities.

The switching element SE can further include a lower electrode 31 and an upper electrode 33. FIG. 7 illustrates such an example. The variable resistance material 32 is located on the upper surface of the lower electrode 31, and the upper electrode 33 is located on the upper surface of the variable resistance material 32.

The MTJ element MTJ includes a ferromagnetic layer 35, an insulating layer 36, and a ferromagnetic layer 37. As an example, as illustrated in FIG. 7, the insulating layer 36 is located on the upper surface of the ferromagnetic layer 35, and the ferromagnetic layer 37 is located on the upper surface of the insulating layer 36.

The ferromagnetic layer 35 is a layer of a material exhibiting ferromagnetism. The ferromagnetic layer 35 has an easy magnetization axis in a direction piercing through interfaces among the ferromagnetic layer 35, the insulating layer 36, and the ferromagnetic layer 37, at an angle of 45° through 90° to the interfaces in one example, or in a direction orthogonal to the interfaces in one example. A magnetization direction of the ferromagnetic layer 35 is not changed even by reading and writing of data in the memory cell MC. The ferromagnetic layer 35 can function as a so-called reference layer (RL). The ferromagnetic layer 35 may include a plurality of layers. Hereinafter, the ferromagnetic layer 35 may be referred to as a reference layer 35.

The insulating layer 36 is a layer of an insulator. The insulating layer 36 includes or consists substantially of, for example, magnesium oxide (MgO) and functions as a so-called tunnel barrier (TB).

The ferromagnetic layer 37 is a layer of a material exhibiting ferromagnetism. The ferromagnetic layer 37 includes or consists substantially of, for example, cobalt iron boron (CoFeB) or iron boride (FeB). The ferromagnetic layer 37 has an easy magnetization axis in a direction piercing through interfaces among the ferromagnetic layer 35, the insulating layer 36, and the ferromagnetic layer 37, at an angle of 45° through 90° to the interfaces in one example, or in a direction orthogonal to the interfaces in one example. A magnetization direction of the ferromagnetic layer 37 can be changed by data writing to the memory cell MC, and the ferromagnetic layer 37 can function as a so-called storage layer (SL). Hereinafter, the ferromagnetic layer 37 may be referred to as storage layer 37.

In a case where a magnetization direction of the storage layer SL is parallel to the magnetization direction of the reference layer RL, the MTJ element MTJ has certain low resistance. In a case where the magnetization direction of the storage layer SL is antiparallel to the magnetization direction of the reference layer RL, the MTJ element MTJ has resistance higher than resistance in the case in which the magnetization direction of the storage layer SL and the magnetization direction of the reference layer RL are antiparallel.

When a current having magnitude equal to or larger than a current Icp having a certain magnitude flows from the storage layer SL toward the reference layer RL, the magnetization direction of the storage layer SL becomes parallel to the magnetization direction of the reference layer RL. When a current Icap having a certain magnitude flows from the reference layer RL toward the storage layer SL, the magnetization direction of the storage layer SL becomes antiparallel to the magnetization direction of the reference layer RL.

The MTJ element MTJ may include further layers.

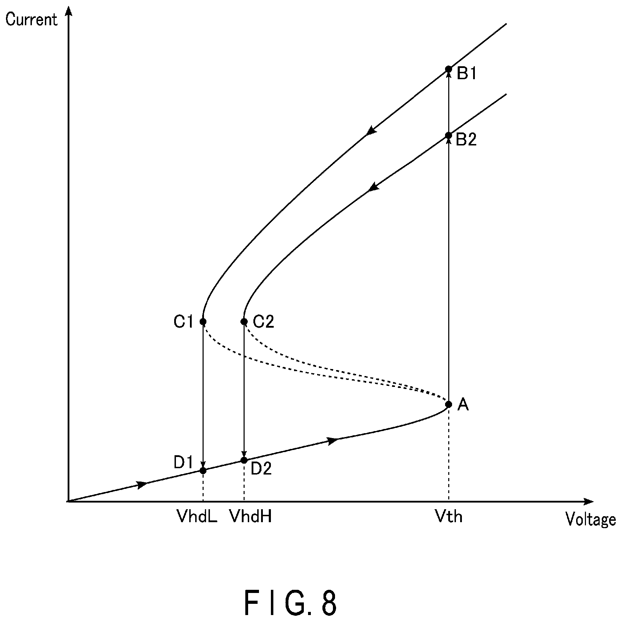

FIG. 8 illustrates an example of voltage and current characteristics of the memory cell of the memory device of the first embodiment. The horizontal axis of a graph indicates the magnitude of a terminal voltage (that is, a difference in potential between both terminals) of the memory cell MC. The vertical axis of the graph indicates, in a logarithmic scale, the magnitude of a current flowing through the memory cell MC. In FIG. 8, virtual characteristics that do not actually appear are indicated by broken lines. FIG. 8 illustrates a case in which the memory cell MC is in the low resistance state and a case in which the memory cell MC is in the high resistance state.

When the voltage is increased from 0, the current keeps increasing until reaching a threshold voltage Vth. Until the voltage reaches the threshold voltage Vth, the switching element SE of the memory cell MC is off, that is, is non-conductive.

When the voltage is further increased and the voltage reaches the threshold voltage Vth, that is, reaches a point A, a relation between the voltage and the current shows a discontinuous change and shows characteristics shown at points B1 and B2. The magnitude of the current at the points B1 and B2 is greatly larger than the magnitude of the current at the point A. This rapid change in the current is based on the switching element SE of the memory cell MC being turned on. The magnitude of the current at the points B1 and B2 depends on a resistance state of the MTJ element MTJ of the memory cell MC.

When the voltage is reduced from the state in which the switching element SE is on, for example, a state in which the voltage and the current indicate a relation shown at the point B1 or B2 and points having a higher voltage than the point B1 or B2, the current keeps decreasing.

When the voltage is further reduced and reaches a certain magnitude, the relation between the voltage and the current shows a discontinuous change. The voltage when the relation between the voltage and the current starts to show discontinuity depends on the terminal voltage of the MTJ element MTJ of the memory cell MC, that is, depends on whether the MTJ element MTJ is in the high resistance state or the low resistance state. When the MTJ element MTJ is in the low resistance state, the relation between the voltage and the current shows discontinuity from a point C1. When the MTJ element MTJ is in the high resistance state, the relation between the voltage and the current shows discontinuity from a point C2. When the voltage reaches the points C1 and C2, the relation between the voltage and the current shows characteristics shown at points D1 and D2. The magnitudes of the currents at the points D1 and D2 are respectively greatly smaller than the magnitudes of the currents at the points C1 and C2. This rapid change in the current is based on the switching element SE of the memory cell MC being turned off.

The terminal voltage at the point D1 of the memory cell MC including the MTJ element MTJ in the low resistance state is referred to as low hold voltage VhdL. The terminal voltage at the point D2 of the memory cell MC including the MTJ element MTJ in the high resistance state is referred to as high hold voltage VhdH.

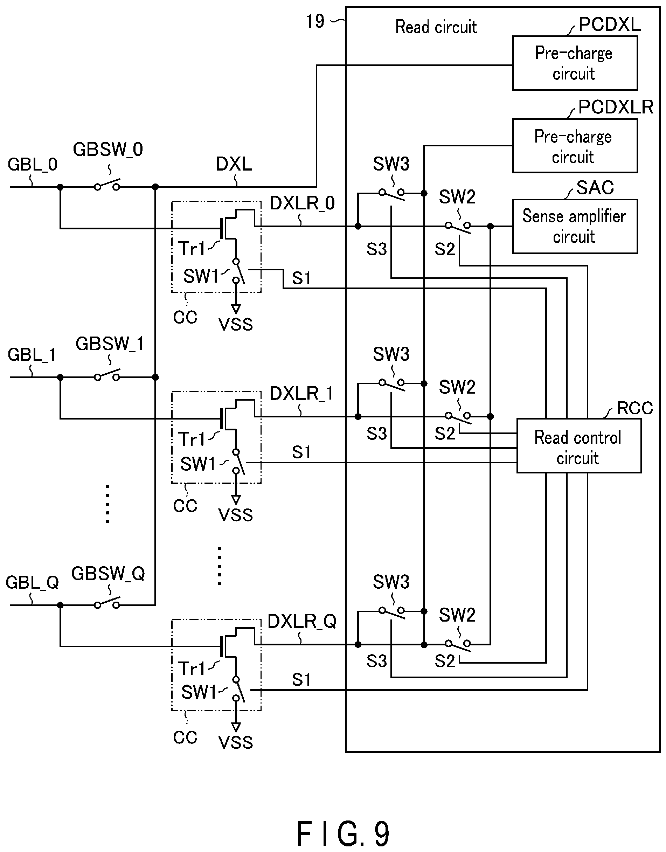

FIG. 9 is a diagram illustrating components of a conversion circuit and a reading circuit of the memory device of the first embodiment, coupling of the components, and related components. FIG. 9 illustrates an example of Q + 1 global bit lines GBL_0 to GBL_Q.

The memory device 1 includes the same number of interconnects DXLR as the number of global bit lines GBL, that is, includes Q + 1 interconnects DXLR_0 to DXLR_Q.

Each conversion circuit CC includes an n-type MOSFET Tr1 and a switch SW1. The transistor Tr1 and the switch SW1 are coupled in series between a single interconnect DXLR and a node that receives a ground voltage (or reference voltage) VSS. The switch SW1 is turned on or off based on a signal S1. The transistor Tr1 is coupled to a single global bit line GBL at the gate.

The read circuit 19 includes a read control circuit RCC, a pre-charge circuit PCDXL, a pre-charge circuit PCDXLR, a sense amplifier circuit SAC, the same number of switches SW2 as the number of global bit lines GBL, and the same number of switches SW3 as the number of global bit lines GBL. That is, the read circuit 19 includes Q + 1 switches SW2 and Q + 1 switches SW3.

Each switch SW2 is coupled between a single interconnect DXLR and the sense amplifier circuit SAC. Each switch SW2 is turned on or off based on a signal S2. The plurality of different switches SW2 receives a plurality of different signals S2. Accordingly, the switches SW2 are individually turned on or off.

Each switch SW3 is coupled between a single interconnect DXLR and the pre-charge circuit PCDXLR. Each switch SW3 is turned on or off based on a signal S3 described later. The plurality of different switches SW3 receives a plurality of different signals S3. Accordingly, the switches SW3 are individually turned on or off.

The pre-charge circuit PCDXL is a circuit that applies a voltage to the interconnect DXL. The pre-charge circuit PCDXL applies a pre-charge voltage VPRCH and an unselect voltage VUSEL to the interconnect DXL. The unselect voltage VUSEL is higher than the ground voltage VSS. The pre-charge voltage VPRCH is higher than the unselect voltage VUSEL. In one example, the pre-charge voltage VPRCH and the unselect voltage VUSEL are supplied from the voltage generator 16. In one example, the unselect voltage VUSEL has half the height of the pre-charge voltage VPRCH.

The pre-charge circuit PCDXLR is a circuit that applies a pre-charge voltage VPC to the interconnect DXLR. In one example, the pre-charge voltage VPC has the same or approximately the same magnitude as the unselect voltage VUSEL. The following description is based on this example.

The read control circuit RCC controls data reading. The read control circuit RCC controls on or off of the switches SW1, SW2, and SW3, that is, outputs the signals S1, S2, and S3.

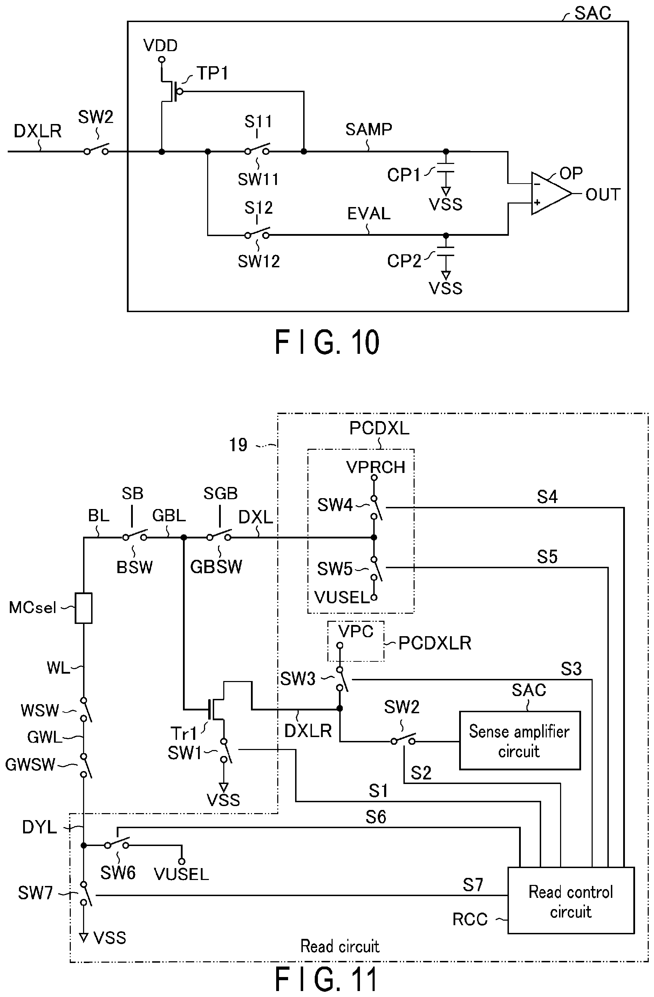

FIG. 10 is a diagram illustrating components of a sense amplifier circuit of a memory device according to the first embodiment and coupling of the components. As illustrated in FIG. 10, a sense amplifier circuit SAC includes switches SW11 and SW12, capacitors CP1 and CP2, and a p-type MOSFET TP1.

The switch SW11 is coupled between one end of each switch SW2 and a node (or interconnect) SAMP. The switch SW11 is turned on or off based on a signal S11.

The switch SW12 is coupled between one end of each switch SW2 and a node (or interconnect) EVAL. The switch SW12 is turned on or off based on a signal S12.

The capacitor CP1 is coupled between the node SAMP and a node that receives the ground voltage VSS. The capacitor CP2 is coupled between the node EVAL and a node that receives the ground voltage VSS.

The transistor TP1 is coupled between a node that receives a power supply voltage VDD and one end of each switch SW2. The transistor TP1 is coupled to the node SAMP at the gate.

An operational amplifier circuit OP is coupled to the node SAMP at an inverting input terminal. The operational amplifier circuit OP is coupled to the node EVAL at a noninverting input terminal.

FIG. 11 is a diagram illustrating an example of components of the reading circuit of the memory device of the first embodiment and coupling of the components. FIG. 11 also illustrates, as representatives, a single selected memory cell MCsel, a single global bit line GBL, a conversion circuit CC coupled to the global bit line GBL, an interconnect DXLR coupled to the conversion circuit CC, and related components.

In one example, the pre-charge circuit PCDXL includes switches SW4 and SW5. The switch SW4 is coupled between a node that receives the pre-charge voltage VPRCH and the interconnect DXL. The switch SW4 is turned on or off based on a signal S4.

The switch SW5 is coupled between the interconnect DXL and a node that receives the unselect voltage VUSEL. The switch SW5 is turned on or off based on a signal S5.

The read circuit 19 further includes switches SW6 and SW7 and a node that receives the pre-charge voltage VPC.

The switch SW6 is coupled between the interconnect DYL and a node that receives the unselect voltage VUSEL. The switch SW6 is turned on or off based on a signal S6.

The switch SW7 is coupled between the interconnect DYL and a node that receives the ground voltage VSS. The switch SW7 is turned on or off based on a signal S7.

A node that receives the pre-charge voltage VPC is coupled to a single interconnect DXLR via a single switch SW3.

The read control circuit RCC outputs the signals S1, S2, S3, S4, S5, S6, and S7.

While receiving the signal S1 at the high level or the "H" level, the switch SW1 is in an on state, and is maintained in a state in which one end and the other end of the switch SW1 are electrically coupled. While receiving the signal S1 at the low level or the "L" level, the switch SW1 is in an off state, and is maintained in a state in which one end and the other end of the switch SW1 are electrically uncoupled from each other.

The same applies to the switch SWn and the signal Sn, where n is an integer of 2 or more. That is, the description of the switch SW1 applies to the description of the switch SWn by replacing the switch SW1 with the switch SWn, and the description of the signal S1 applies to the description of the signal Sn by replacing the signal S1 with the signal Sn.

### 1.2. Operations

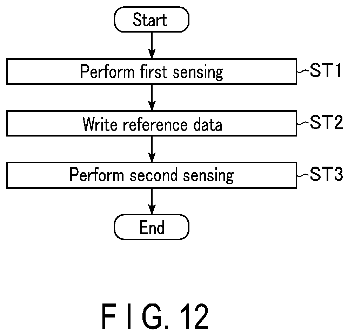

FIG. 12 is a diagram illustrating a flow of data reading in the memory device of the first embodiment. The flow of FIG. 12 is started when the memory device 1 determines that reading of data from the selected memory cell MCsel is to be started. In one example, the determination on the execution of data reading is based on the memory device 1 receiving a data reading command.

As illustrated in FIG. 12, first sensing is performed (ST1). The sensing refers to acquiring data determined as being stored in the selected memory cell MCsel based on the resistance state of the MTJ element MTJ of the selected memory cell MCsel. During the first sensing, the switch SW11 of the sense amplifier circuit SAC is kept on, and the switch SW12 is kept off. In this state, a voltage based on the resistance state of the MTJ element MTJ of the selected memory cell MCsel is applied to the interconnect DXLR. Accordingly, a potential based on the resistance state of the MTJ element MTJ of the selected memory cell MCsel appears at the node SAMP. After the potential appears at the node SAMP, the switch SW11 is turned off. Accordingly, the potential based on the resistance state of the MTJ element MTJ of the selected memory cell MCsel is saved in the node SAMP. The potential of the node SAMP is based on the resistance state of the MTJ element MTJ of the selected memory cell MCsel at the start of data reading and controls the current flowing through the transistor TP1. Therefore, at the start of data reading, the current based on the resistance state of the MTJ element MTJ of the selected memory cell MCsel flows into the interconnect DXLR.

Reference data is written to the selected memory cell MCsel (ST2). The reference data is data of a predetermined fixed value. The reference data may be "0" data or "1" data. The following description is based on an example of "0" data.

Second sensing is performed (ST3). During the second sensing, the switch SW12 of the sense amplifier circuit SAC is kept on, and the switch SW11 is kept off. In this state, a voltage based on the resistance state of the MTJ element MTJ of the selected memory cell MCsel (that is, the voltage based on the low resistance state) is applied to the interconnect DXLR. In addition, a current based on the result of the first sensing flows into the interconnect DXLR. Therefore, the result of the first sensing, that is, a potential based on the resistance state of the MTJ element MTJ of the selected memory cell MCsel at the start of data reading appears on the interconnect DXLR.

When the operational amplifier circuit OP is enabled, data OUT having a value based on the potential of the node SAMP and the potential of the node EVAL is output. The data OUT has a value based on data that is determined as being stored in the selected memory cell MCsel at the start of data reading. In a case where the selected memory cell MCsel stores "0" data at the start of data reading, the data stored in the selected memory cell MCsel at the start of data reading and the written reference data are the same. Data OUT having a value reflecting this fact is output.

On the other hand, in a case where the selected memory cell MCsel stores "1" data at the start of data reading, the data stored in the selected memory cell MCsel at the start of data reading is different from the written reference data. Data OUT having a value reflecting this fact is output.

After the data OUT is output, the data that is determined as being stored in the selected memory cell MCsel at the start of data reading is written to the selected memory cell MCsel.

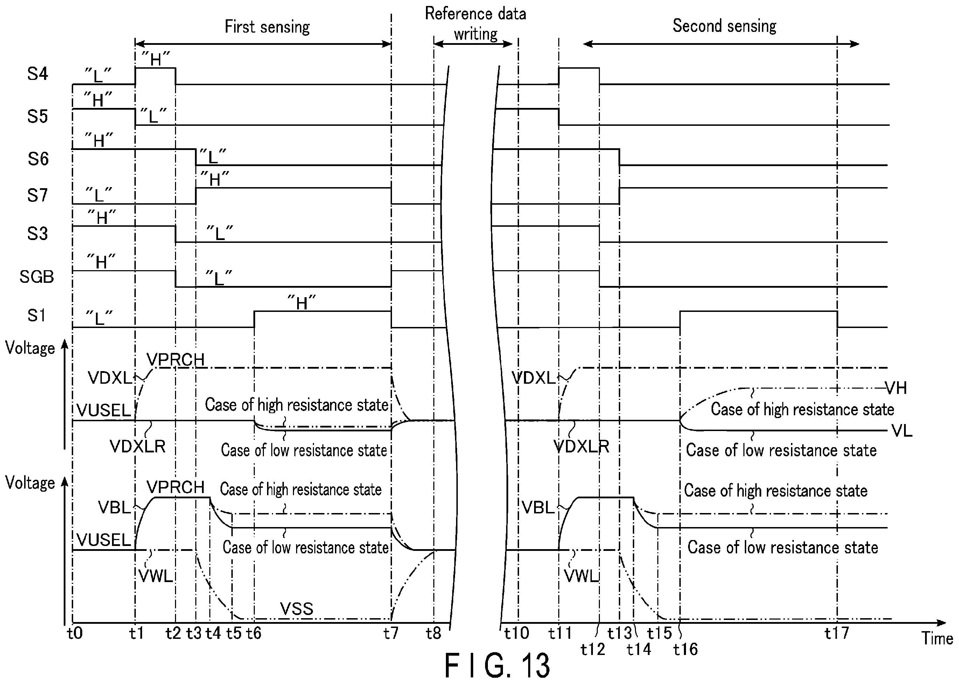

FIG. 13 is a diagram illustrating potentials of several signals and interconnects along time during data reading of the memory device of the first embodiment. FIG. 13 illustrates a state in which one selected memory cell MCsel is selected. That is, the switches BSW, WSW, and GWSW coupled to the selected memory cell MCsel are kept on during the period illustrated in FIG. 13. The operation in the period illustrated in FIG. 13 is started when data reading is started in a state where the selected memory cell MCsel as a data reading target is selected.

Hereinafter, the word line WL coupled to the selected memory cell MCsel may be referred to as selected word line WL. The bit line BL coupled to the selected memory cell MCsel may be referred to as selected bit line BL. The transistor Tr1 coupled to the selected global bit line GBL may be referred to as selected transistor Tr1. The global word line GWL coupled to the selected word line WLsel may be referred to as selected global word line GWL. FIG. 13 illustrates the selected word line WL, the selected bit line BL, the selected global bit line GBL, the selected transistor Tr1, the interconnect DXLR coupled to the selected transistor Tr1, and the selected global word line GWL. FIG. 13 illustrates a signal SGB supplied to the switch GBSW coupled to the selected global bit line GBL. FIG. 13 illustrates the signal S1 of the switch SW1 coupled to the transistor Tr1 having the gate coupled to the selected global bit line GBL.

The switches SW1 coupled to the transistors Tr1 other than the selected transistor Tr1 are kept off over the period illustrated in FIG. 13. The switches GBSW other than the switch GBSW coupled to the selected global bit line GBL are kept off over the period illustrated in FIG. 13.

At time t0, each signal and interconnect have the following potential or level. The signals S4 and S7 have a low level, and the signals S5 and S6 have a high level. Therefore, the switches SW4 and SW7 are off, and the switches SW5 and SW6 are on. The signal SGB has a high level, so that the selected global bit line GBL is coupled to the interconnect DXL. The signal S1 has a low level, so that the selected transistor Tr1 is uncoupled from the node receiving the ground voltage VSS. The signal S3 has a high level, so that the switch SW3 is on.

Based on the fact that the switch SW4 is off and the switch SW5 is on, the potential VDXL of the interconnect DXL has the unselect potential VUSEL. The unselect potential VUSEL is a potential having a magnitude that an interconnect has by receiving the unselect voltage VUSEL, and in one example, has substantially the same magnitude as the unselect voltage VUSEL. Since the signal SGB has a high level, the potential (selected bit line potential) VBL of the selected bit line BL has the same potential as the potential VDXL, that is, the unselect potential VUSEL.

Based on the fact that the switch SW7 is off and the switch SW6 is on, the interconnect DYL receives the unselect voltage VUSEL, so that the potential (selected word line potential) VWL of the selected word line WL has the unselect potential VUSEL.

Based on the fact that the switch SW3 is on, the interconnect DXLR receives the pre-charge voltage VPC, that is, the unselect voltage VUSEL. Therefore, the potential VDXLR of the interconnect DXLR has the pre-charge potential VPC, that is, the unselect potential VUSEL. The pre-charge potential VPC is a potential having a magnitude that an interconnect has by receiving the pre-charge voltage VPC, and in one example, has substantially the same magnitude as the pre-charge voltage VPC.

A period from time t1 to time t8 is a period of the first sensing (step ST1).

At time t1, the signal S4 is set to a high level and the signal S5 is set to a low level. Accordingly, the switch SW4 is turned on, and the switch SW5 is turned off. Therefore, from time t1, the potential VDXL and the selected bit line potential VBL increase to reach the pre-charge potential VPRCH. The pre-charge potential VPRCH is a potential having a magnitude that an interconnect has by receiving the pre-charge voltage VPRCH, and in one example, has substantially the same magnitude as the pre-charge voltage VPRCH.

At time t2, the signal S4 is set to a low level. Accordingly, the switch SW4 is turned off, and the interconnect DXL, the selected global bit line GBL, and the selected bit line BL become to electrically float. After time t2, the potential VDXL and the selected bit line potential VBL remain at the pre-charge potential VPRCH.

At time t2, the signal SGB is set to a low level. Accordingly, the switch GBSW is turned off, and the selected global bit line GBL and the selected bit line BL are uncoupled from the interconnect DXL and become to electrically float.

At time t2, the signal S3 is set to a low level. Accordingly, the switch SW3 is turned off, and the pre-charge to the interconnect DXLR is stopped.

At time t3, the signal S6 is set to a low level and the signal S7 is to a high level. Accordingly, the switch SW6 is turned off, and the switch SW7 is turned on. Therefore, the selected word line potential VWL decreases toward the ground potential VSS. The ground potential VSS is a potential of a magnitude that an interconnect has by receiving the ground voltage VSS, and in one example, has substantially the same magnitude as the ground voltage VSS.

At time t4, the difference between the selected word line potential VWL and the selected bit line potential VBL reaches a threshold voltage Vth. Accordingly, the switching element SE of the selected memory cell MCsel is turned on. Therefore, the selected word line WL is coupled to the selected bit line BL via the switching element SE in the on state in the selected memory cell MCsel. Accordingly, a cell current flows from the selected bit line BL toward the selected word line WL.

Since the selected bit line BL is electrically floating, the selected bit line potential VBL falls when the cell current flows. At this time, the selected bit line potential VBL falls at different speeds depending on the resistance state of the MTJ element MTJ of the selected memory cell MCsel. The selected bit line potential VBL in a case where the MTJ element MTJ of the selected memory cell MCsel is in the high resistance state decreases more slowly than when the selected bit line potential VBL decreases in a case where the MTJ element MTJ of the selected memory cell MCsel is in the low resistance state.

At time t5, the selected bit line potential VBL has a magnitude based on the resistance state of the MTJ element MTJ of the selected memory cell MCsel. That is, the difference between the selected bit line potential VBL and the selected word line potential VWL reduces due to the falling of the selected bit line potential VBL. Accordingly, when the terminal voltage of the selected memory cell MCsel reaches a certain level, the switching element SE of the selected memory cell MCsel is turned off. As a result, the falling of the selected bit line potential VBL stops, and the selected bit line potential VBL has a certain magnitude.

By the operations from time t3 to time t5, the selected bit line potential VBL and thus the selected global bit line GBL have a potential based on the state of the selected memory cell MCsel.

At time t6, the signal S1 is set to a high level. Accordingly, the switch SW1 is turned on, and a current path is formed between the transistor Tr1 and the node that receives the ground voltage VSS. At time t6, the selected global bit line GBL has a potential according to the state of the selected memory cell MCsel, and thus, a voltage based on the state of the selected memory cell MCsel is applied to the gate of the transistor Tr1. Therefore, the potential VDXLR becomes a potential based on the state of the selected memory cell MCsel. In this way, a cell current of a magnitude based on the state of the selected memory cell MCsel is converted into a potential (voltage).

At time t7, the signal S1 is set to a low level. Accordingly, the switch SW1 is turned off, and the transistor Tr1 is uncoupled from the node receiving the voltage VSS. At least from time t6 to time t7, the switch SW11 of the sense amplifier circuit SAC is kept on and the switch SW12 is kept off. Accordingly, the potential VDXLR is saved in the node SAMP.

At time t7, the signal SGB is set to a high level. Accordingly, the switch GBSW is turned on, and the selected global bit line GBL and the interconnect DXL are coupled to each other.

A period from time t8 to before time t10 is a period of reference data writing (step ST2).

At time t10, the signals S4 and S7 have a low level, and the signals S3, S5, S6, and SGB have a high level. Therefore, the switches SW4 and SW7 are off, and the switches SW3, SW5, SW6, and GBSW are on.

Based on the fact that the switch SW4 is off and the switch SW5 is on, the potential VDXL has the unselect potential VUSEL. In addition, based on the fact that the switch GBSW is on, the selected bit line potential VBL has the same potential as the potential VDXL, that is, the unselect potential VUSEL.

Based on the fact that the switch SW7 is off and the switch SW6 is on, the selected word line potential VWL has the unselect potential VUSEL.

Based on the fact that the switch SW3 is on, the potential VDXLR has the pre-charge potential VPC, that is, the unselect potential VUSEL.

A period from time t11 to time t17 is a period of second sensing (step ST3). The changes in the level of the signal and the potential of the interconnect at times t11, t12, t13, t14, t15, t16, and t17 are the same as the changes in the level of the signal and the potential of the interconnect at times t1, t2, t3, t4, t5, t6, and t7, respectively.

At time t16, the selected global bit line GBL has a potential according to the state of the selected memory cell MCsel, and thus, a voltage based on the low resistance state of the MTJ element MTJ of the selected memory cell MCsel is applied to the gate of the transistor Tr1. Therefore, the transistor Tr1 flows a current of an amount based on the low resistance state of the MTJ element MTJ of the selected memory cell MCsel between the interconnect DXLR and the node that receives the ground voltage VSS. In addition, the interconnect DXLR receives an amount of current based on the result of the first sensing via the transistor TP1 of the sense amplifier circuit SAC. Therefore, from time t16, the potential VDXLR starts to change toward a magnitude determined based on the result of the first sensing. In a case where the result of the first sensing indicates that the MTJ element MTJ of the selected memory cell MCsel is in the high resistance state, the potential VDXLR rises and becomes the potential VH. In a case where the result of the first sensing indicates that the MTJ element MTJ of the selected memory cell MCsel is in the low resistance state, the potential VDXLR falls and becomes the potential VL.

At least from time t16 to time t17, the switch SW11 of the sense amplifier circuit SAC is kept off and the switch SW12 is kept on. Accordingly, the potential VDXLR is saved in the node EVAL.

Next, the data OUT determined based on the potential of the node SAMP and the potential of the node EVAL and determined as being stored in the selected memory cell MCsel is output from the sense amplifier circuit SAC.

### 1.3. Advantages (Advantageous Effects)

According to the first embodiment, it is possible to provide a memory device that operates at a high speed as described below.

As a reference memory device for comparison, a circuit in which the transistor Tr1 is coupled to the interconnect DXL without providing the interconnect DXLR can be considered. In this case, parasitic capacitances in many conversion circuits CC are added to the interconnect DXL. This will take time to charge and discharge the interconnect DXL.

In the reference memory device, the potential based on the state of the selected memory cell MCsel starts to be reflected from time corresponding to time t3 in FIG. 13. The potential VDXL at the start of reflection has the same potential as the selected bit line potential VBL, that is, the pre-charge potential VPRCH. Therefore, in the second sensing, the potential VDXL decreases from the pre-charge potential VPRCH to the potential VH or VL based on the state of the selected memory cell MCsel. Since the potential VL has a large difference from the pre-charge potential VPRCH, it takes time for the potential VDXL to reach the potential VL.

As above, since it takes time to charge and discharge the interconnect DXL and to settle the potential VDXL, it takes time to read data.

According to the first embodiment, a single conversion circuit CC and a single interconnect DXLR are provided for each global bit line GBL, and each transistor Tr1 is coupled to the interconnect DXLR instead of the interconnect DXL. Therefore, the parasitic capacitances of the conversion circuits CC are not added to the interconnect DXL. Furthermore, according to the first embodiment, since the transistor Tr1 is coupled to the interconnect DXLR, the potential of the interconnect DXLR does not need to be set to the pre-charge potential VPRCH unlike the reference memory device, and can be set to any pre-charge potential VPC. Therefore, the potential VDXLR to which the potential based on the state of the selected memory cell MCsel starts to be reflected can be a potential close to the potential VH and/or the potential VL. This leads to a reduction in time from when the potential based on the state of the selected memory cell MCsel starts to be reflected in the potential VDXLR until the potential is reflected. Therefore, the memory device 1 can read data at high speed.

According to the first embodiment, the transistor Tr1 is not coupled to the interconnect DXL. Therefore, the high voltage applied to the interconnect DXL is not applied to the transistor Tr1 during data writing or the like. Therefore, the transistor Tr1 does not need to be a high-withstand-voltage transistor, so that current consumption can be suppressed and circuits can be easily designed.

### 2. Second Embodiment

A second embodiment is different from the first embodiment in the number of sets of conversion circuit CC, pre-charge circuit PCDXLR, and sense amplifier circuit SAC.

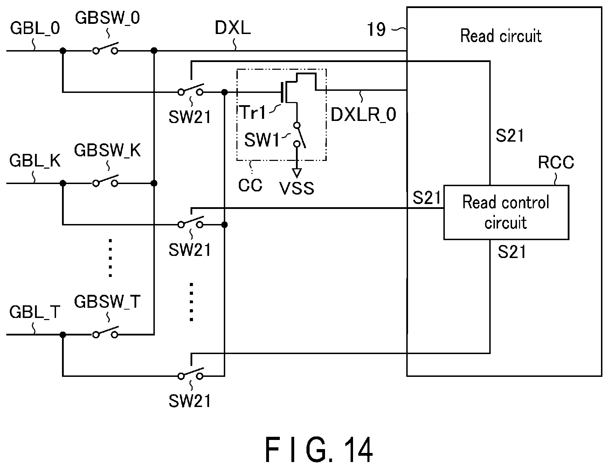

FIG. 14 is a diagram illustrating components of a memory device of the second embodiment and coupling of the components. FIG. 14 illustrates several global bit lines GBL and their surroundings.

As illustrated in FIG. 14, a memory device 1b of the second embodiment includes T (T is an integer of 2 or more) switches SW21. K is an integer of 1 or more and less than T. Each of the T global bit lines GBL is coupled to the gate of a single transistor Tr1 via a single switch SW21. That is, the T global bit lines GBL are coupled to a single conversion circuit CC via the switches SW21. Accordingly, a single conversion circuit CC and a single interconnect DXLR are shared by the T global bit lines GBL. FIG. 14 illustrates a single interconnect DXLR_0 as a representative.

Each switch SW21 is turned on or off based on a signal S21. The plurality of different switches SW21 receives a plurality of different signals S21. Accordingly, the switches SW21 are individually turned on or off.

According to the second embodiment, the same advantages as those of the first embodiment can be obtained. Further, according to the second embodiment, the conversion circuit CC and the interconnect DXLR are shared by the plurality of global bit lines GBL. This eliminates the need to provide the same number of conversion circuits CC as the global bit lines GBL and the same number of interconnects DXLR as the global bit lines GBL. Therefore, the same advantages as those of the first embodiment can be obtained by a simple circuit.

In addition, according to the second embodiment, the number of conversion circuits CC and thus the number of transistors Tr1 are smaller than the numbers in the first embodiment. Accordingly, the unavoidable variation in the characteristics of the transistors Tr1 is smaller than that in the first embodiment. This makes it easy to cope with the variations in characteristics of the transistors Tr1. That is, although it is necessary in general to secure a margin of the operation in accordance with the transistor Tr1 having the worst characteristic in order to cope with the variation, the margin can be reduced as the variation is small in the second embodiment.

All or part of the above embodiments may be described as in the following supplementary notes, but are not limited to the following.

### (Supplementary Note 1)

A memory device comprising:
a first memory cell that includes a first variable resistance element and a first switching element coupled to the first variable resistance element;
a first interconnect coupled to the first memory cell;
a first switch that has a first end and a second end, the first end being coupled to the first interconnect;
a second interconnect coupled to the second end; and
a first pre-charge circuit coupled to the second interconnect;
a first transistor that has a third end, a fourth end, and a gate, the third end being coupled to a first node receiving a first voltage, the gate being coupled to the first interconnect;
a third interconnect coupled to the fourth end of the first transistor; and
a sense amplifier circuit coupled to the third interconnect.

### (Supplementary Note 2)

The memory device according to Supplementary Note **1,** wherein
the fourth end of the first transistor is not coupled to the second interconnect.

### (Supplementary Note 3)

The memory device according to Supplementary Note 1, further comprising:
a second memory cell that includes a second variable resistance element and a second switching element coupled to the second variable resistance element;
a fourth interconnect coupled to the second memory cell;
a second switch that has a fifth end and a sixth end, the fifth end being coupled to the fourth interconnect;
a second transistor that has a seventh end, an eighth end, and a gate, the seventh end being coupled to the first node, the gate coupled to the fourth interconnect; and
a fifth interconnect between the eighth end of the second transistor and the sense amplifier circuit.

### (Supplementary Note 4)

The memory device according to Supplementary Note 3, wherein
the fourth end of the first transistor is not coupled to the second interconnect, and
the eighth end of the second transistor is not coupled to the second interconnect.

### (Supplementary Note 5)

The memory device according to Supplementary Note 1, further comprising
a write circuit coupled to the second interconnect.

### (Supplementary Note 6)

The memory device according to Supplementary Note 1, wherein
the second interconnect is pre-charged by the first pre-charge circuit, and
a signal based on data stored in the first memory cell is output from the sense amplifier circuit based on a potential of the third interconnect.

### (Supplementary Note 7)

The memory device according to Supplementary Note 1, further comprising
a second pre-charge circuit coupled to the third interconnect.

### (Supplementary Note 8)

The memory device according to Supplementary Note 7, further comprising
a sixth interconnect that is coupled to an end of the first memory cell opposite to an end coupled to the first interconnect, wherein
the third interconnect is pre-charged by the second pre-charge circuit,
the first switch is kept on over a first period,
the second interconnect receives a second voltage by the first pre-charge circuit during the first period,
the first memory cell is uncoupled from the second interconnect over a second period after the second interconnect receives the second voltage, and
the sixth interconnect receives a third voltage lower than the second voltage during the second period.

### (Supplementary Note 9)

The memory device according to Supplementary Note 8, wherein
the third interconnect is pre-charged by the second pre-charge circuit after the second period,
after the third interconnect is pre-charged after the second period,
the first switch is kept on over a third period,
the second interconnect receives the second voltage by the first pre-charge circuit during the third period,
after the second interconnect receives the second voltage, the first memory cell is uncoupled from the second interconnect over a fourth period,
the sixth interconnect receives the third voltage during the fourth period, and
data based on a potential of the third interconnect during the second period and a potential of the third interconnect during the fourth period is output from the sense amplifier circuit.

### (Supplementary Note 10)

The memory device according to Supplementary Note 9, wherein
the sense amplifier circuit includes:
a seventh interconnect that is coupled to the third interconnect via a third switch and has a capacitance;
an eighth interconnect that is coupled to the third interconnect via a fourth switch and has a capacitance; and
an operational amplifier that has an inverting input terminal coupled to the seventh interconnect and a noninverting input terminal coupled to the eighth interconnect.

### (Supplementary Note 11)

The memory device according to Supplementary Note 10, wherein
the potential of the third interconnect during the second period is saved in the seventh interconnect, and
the potential of the third interconnect during the fourth period is saved in the eighth interconnect.

### (Supplementary Note 12)

The memory device according to Supplementary Note 11, further comprising
a third transistor that is coupled between a node receiving a fourth voltage higher than the third voltage and the third interconnect, and has a gate coupled to the seventh interconnect.

### (Supplementary Note 13)

The memory device according to Supplementary Note 1, further comprising:
a fifth switch between the first interconnect and the gate of the first transistor;
a ninth interconnect; and
a sixth switch between the ninth interconnect and the gate of the first transistor.

### (Supplementary Note 14)

The memory device according to Supplementary Note 13, further comprising:
a third memory cell that includes a second variable resistance element and a second switching element coupled to the second variable resistance element, and is coupled to the ninth interconnect; and
a seventh switch between a fifth end coupled to the ninth interconnect and the second interconnect.

### (Supplementary Note 15)

The memory device according to Supplementary Note 13, wherein
the fourth end of the first transistor is not coupled to the second interconnect.

### (Supplementary Note 16)

The memory device according to Supplementary Note 13, further comprising
a second pre-charge circuit coupled to the third interconnect.

### (Supplementary Note 17)

The memory device according to Supplementary Note 1, wherein
the first variable resistance element includes a magnetoresistance effect element.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the scope of the inventions. The accompanying claims are intended to cover such forms or modifications as would fall within the scope of the inventions.

## Claims

1. A memory device comprising:
a first memory cell (MC) that includes a first variable resistance element and a first switching element coupled to the first variable resistance element;
a first interconnect (GBL_0) coupled to the first memory cell;
a first switch (GBSW_0) that has a first end and a second end, the first end being coupled to the first interconnect;
a second interconnect (DXL) coupled to the second end; and
a first pre-charge circuit (PCDXL) coupled to the second interconnect;
a first transistor (Tr1) that has a third end, a fourth end, and a gate, the third end being coupled to a first node receiving a first voltage, the gate being coupled to the first interconnect;
a third interconnect (DXLR_0) coupled to the fourth end of the first transistor; and
a sense amplifier circuit (SAC) coupled to the third interconnect.

2. The memory device according to claim 1, wherein
the fourth end of the first transistor is not coupled to the second interconnect.

3. The memory device according to claim 1 or 2, further comprising:
a second memory cell that includes a second variable resistance element and a second switching element coupled to the second variable resistance element;
a fourth interconnect coupled to the second memory cell;
a second switch that has a fifth end and a sixth end, the fifth end being coupled to the fourth interconnect;
a second transistor that has a seventh end, an eighth end, and a gate, the seventh end being coupled to the first node, the gate coupled to the fourth interconnect; and
a fifth interconnect between the eighth end of the second transistor and the sense amplifier circuit.

4. The memory device according to claim 3, wherein
the eighth end of the second transistor is not coupled to the second interconnect.

5. The memory device according to any preceding claim, further comprising
a write circuit coupled to the second interconnect.

6. The memory device according to any preceding claim, wherein
the second interconnect is pre-charged by the first pre-charge circuit, and
a signal based on data stored in the first memory cell is output from the sense amplifier circuit based on a potential of the third interconnect.

7. The memory device according to any preceding claim, further comprising
a second pre-charge circuit coupled to the third interconnect.

8. The memory device according to claim 7, further comprising
a sixth interconnect that is coupled to an end of the first memory cell opposite to an end coupled to the first interconnect, wherein
the third interconnect is pre-charged by the second pre-charge circuit,
the first switch is kept on over a first period,
the second interconnect receives a second voltage by the first pre-charge circuit during the first period,
the first memory cell is uncoupled from the second interconnect over a second period after the second interconnect receives the second voltage, and
the sixth interconnect receives a third voltage lower than the second voltage during the second period.

9. The memory device according to claim 8, wherein the third interconnect is pre-charged by the second pre-charge circuit after the second period,
after the third interconnect is pre-charged after the second period,
the first switch is kept on over a third period,
the second interconnect receives the second voltage by the first pre-charge circuit during the third period,
after the second interconnect receives the second voltage, the first memory cell is uncoupled from the second interconnect over a fourth period,
the sixth interconnect receives the third voltage during the fourth period, and
data based on a potential of the third interconnect during the second period and a potential of the third interconnect during the fourth period is output from the sense amplifier circuit.

10. The memory device according to claim 8 or 9, wherein
the sense amplifier circuit includes:
a seventh interconnect that is coupled to the third interconnect via a third switch and has a capacitance;
an eighth interconnect that is coupled to the third interconnect via a fourth switch and has a capacitance; and
an operational amplifier that has an inverting input terminal coupled to the seventh interconnect and a noninverting input terminal coupled to the eighth interconnect.

11. The memory device according to claim 10, wherein
the potential of the third interconnect during the second period is saved in the seventh interconnect, and
the potential of the third interconnect during the fourth period is saved in the eighth interconnect.

12. The memory device according to claim 10 or 11, further comprising
a third transistor that is coupled between a node receiving a fourth voltage higher than the third voltage and the third interconnect, and has a gate coupled to the seventh interconnect.

13. The memory device according to any preceding claim, further comprising:
a fifth switch between the first interconnect and the gate of the first transistor;
a ninth interconnect; and
a sixth switch between the ninth interconnect and the gate of the first transistor.

14. The memory device according to claim 13, further comprising:
a third memory cell that includes a second variable resistance element and a second switching element coupled to the second variable resistance element, and is coupled to the ninth interconnect; and
a seventh switch between a fifth end coupled to the ninth interconnect and the second interconnect.

15. The memory device according to any preceding claim, wherein
the first variable resistance element includes a magnetoresistance effect element.
